# EUROPEAN PATENT APPLICATION

(11) **EP 0 611 992 A1**
(43) Date of publication of application: **24.08.1994**
(21) Application number: 93200457.5
(22) Date of filing: 18.02.1993
(51) Int. Cl.: G03C 8/06, G03F 7/07

(54) **A silver salt diffusion transfer material and method for making an image therewith**

(71) Applicant: AGFA-GEVAERT naamloze vennootschap, B-2640 Mortsel (BE)
(72) Inventor: Hieronymus, Andriessen, c/o Agfa-Gevaert N.V., B-2640 Mortsel, (BE); Lamotte, Johan, c/o Agfa-Gevaert N.V., B-2640 Mortsel, (BE)

(57) **Abstract**

The present invention provides a photographic material comprising on a support a layer combining photosensitive and image receiving properties, said layer containing (i) light sensitive silver halide particles, (ii) a substantially light insensitive silver salt having a speed of at least a factor 10 less than said light sensitive silver halide particles and (iii) physical development nuclei. The present invention further provides a method for obtaining an image with said photographic material according to the silver salt diffusion transfer process.

## Description

### 1. Field of the invention.

The present invention relates to a mono-sheet silver salt diffusion transfer material and method for producing direct-positive images therewith.

### 2. Background of the invention.

In silver halide photography a photographic method, according to which a positive image is made without the use of a negative image or an intermediary process producing a negative image, is called a direct-positive method and a photographic light-sensitive element is called a direct-positive element.

Two main types for producing direct-positive image are known. According to a first class use is made of a photographic element containing a direct positive silver halide emulsion. Such types of photographic elements are disclosed in for example US-P-3,364,026, US-P-3,501,305, US-P-2,456,953 and US-P-3,761,276. These types of photographic material are of rather low speed.

According to the second class use is made of the silver salt diffusion transfer method. The principles of the silver complex diffusion transfer reversal process, hereinafter called DTR-process, have been described e.g. in US-P-2,352,014 and the book "Photographic Silver Halide Diffusion Processes" by André Rott and Edith Weyde - The Focal Press -London and New York, (1972).

According to the DTR process, a silver complex salt is image-wise transferred by diffusion from the image-wise exposed silver halide emulsion layer into the image receiving layer, where it is converted to a silver image usually in the presence of physical development nuclei. For this purpose, the image-wise exposed silver halide emulsion layer is developed in the presence of a developing agent and non-developed silver halide is converted by means of a silver halide complexing agent into a soluble silver complex salt while in contact with an image receiving layer.

At the exposed areas of the silver halide emulsion layer the silver halide is developed (chemical development) and thus cannot be dissolved any more to diffuse to the receiving layer.

At the unexposed areas of the silver halide emulsion layer the silver halide is converted to a soluble silver complex salt and is transferred to the receiving layer, where it forms a silver image usually in the presence of physical development nuclei.

The DTR process includes (a) a so-called "two-sheet" type where the silver halide emulsion layer and the image receiving layer are contained on separate supports and are brought in contact with each other at the time of diffusion transfer development to produce the silver image in the receiving sheet and (b) a so-called "mono-sheet" type where both the emulsion layer and the layer containing the physical development nuclei are contained on the same support.

According to the DTR process a direct positive image can thus be obtained either with a "mono-sheet" or "two-sheet" type. Mono-sheet type DTR-materials are well known for producing lithographic printing plates. However for producing images this type of DTR-material is less suited because of a rather large density in the non-image areas. A DTR-material of the two-sheet type can yield direct positive image having a high gradient and low density in the non-image areas but is inconvenient for applications such as e.g. Computer Output to Microfilm (COM).

It is furthermore desirable that the image is of high resolution and sharpness.

### 3. Summary of the invention.

It is an object of the present invention to obtain images of high density in the image areas, low density in the non-image areas (preferably less than 0.4), improved resolution, sharpness and contrast using a mono-sheet DTR-material.

According to the present invention there is provided a photographic material comprising on a support a layer combining photosensitive and image receiving properties, said layer containing (i) light sensitive silver halide particles (ii) a substantially light insensitive silver salt having a speed of at least a factor 10 less than said light sensitive silver halide particles and (iii) physical development nuclei.

According to the present invention there is also provided a method for obtaining direct-positive images with the above defined photographic material.

### 4. Detailed description of the invention.

It has been found that information-wise exposure and subsequent development according to the DTR-process of a photographic material as defined above yields images of high densities in the image areas and low densities in the non-image areas generally of not more than 0.4. Furthermore images of improved sharpness and resolution can be obtained so that the photographic material can be used in e.g. COM-applications.

It is believed that the working of the present invention in case of negative working light sensitive silver halide particles is as follows. Upon information-wise exposure a latent image will be formed by the light sensitive or photosensitive silver halide particles and during subsequent development in the presence of developing agent(s) and silver halide solvent(s) the light sensitive silver halide particles will be developed to silver at the exposed parts. At the same time the substantially light insensitive silver salts will be dissolved by the silver halide solvent(s) and deposited as silver in the exposed areas on the silver particles resulting from the development of the light sensitive silver halide and on the physical development nuclei contained in the photosensitive layer in the non-exposed areas. In the non-exposed areas the light sensitive silver halide will not be developed to silver and may also be dissolved by the silver halide solvent(s) and deposited as silver on the physical development nuclei.

Preferred features of the photographic material according to the invention for obtaining images of good quality therewith are as follows. Firstly, the coverage power of the light sensitive silver halide is preferably as low as possible to obtain images of low density in the non-image areas. This can be achieved by using a light sensitive silver halide having an average diameter of at least 0.5µm, preferably at least 0.6µm and most preferably at least 0.8µm and by keeping the ratio of the coverage of light sensitive silver halide (in g/m² expressed as AgNO₃) to said average diameter (in µm) below 2. However the coverage of light sensitive silver halide is preferably not less than 0.2g/m² expressed as g AgNO₃/m².

By the diameter of a silver halide grain is meant the diameter of a hypothetical sphere with an equivalent volume as the corresponding silver halide grain. The average diameter of the silver halide grains thus being the average of all these diameters. The average diameter can be measured according to e.g. the method described by G. Möller disclosed on the International Congres of Photographic Science (ICPS) held in Moskou from July 29th to August 5th 1970.

Secondly the speed of the substantially light insensitive silver salt is preferably at least a factor 10 less than the speed of the light sensitive silver halide under the same conditions of exposure and development. By keeping this difference in speed the formation of a latent image by the substantially light insensitive silver salt can be avoided and thus the build up of density in the non-image areas due to development of said latent image.

A third feature is that the light sensitive silver halide emulsion is preferably well stabilized in order to avoid fogging of said emulsion.

In order to obtain images of high density and good contrast it is preferred that the weight ratio of substantially light insensitive silver salt to photosensitive silver salt particles is between 1:2 and 10:1 and more preferably between 1:1 and 5:1 and most preferably between 1:1 and 3:1.

Preferred substantially light insensitive silver salts for use in accordance with the present invention are preferably water insoluble silver salts e.g. a silver halide, bromate, molybdate, oxalate, chromate, iodate, isocyanate, thioisocyanate, cyanide, citrate, phosphate, oxide etc.. Said water insoluble silver salts may be prepared using the precipitation reaction of the water soluble salt of the desired anion of the insoluble silver salt with a water soluble silver salt, e.g. silver nitrate, in the presence of a hydrophilic binder.

Preferably said silver salt particles are readily transferable by diffusion to the physical development nuclei during the DTR-process. For this purpose silver salts containing at least 70 mole% of chloride are preferred in the present invention. The substantially light insensitive silver salt particles in connection with the present invention are preferably not chemically and not spectrally sensitized. It is furthermore advantageous that the particle size of said silver salt is small i.e. an average diameter of less than 0.3µm is preferred. Said silver salt is preferably also doped with Rh³⁺, Ir⁴⁺, Cd²⁺, Zn²⁺ or Pb²⁺ to reduce the light sensitivity of the silver halide. The said silver salt particles may further be desensitized on the surface with a desensitizing agent well known to those skilled in the art. Examples of desensitizing agent are disclosed in e.g. the US Patents 2,930,644, 3,431,111, 3,492,123, 3,501,310, 3,501,311, 3,574,629, 3,579,345, 3,598,595, 3,592,653, 4.820.625, 3.933.498, and GB 1.192.384. Further desensitizing agents suitable for use in accordance with the present invention are described e.g. by P. Glafkides in "Chimie et Physique Photographique", Paul Montel, Paris (1967).

The photosensitive silver halide particles can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al. in "Making and Coating Photographic Emulsion", The Focal Press, London (1966).

The photosensitive silver halide particles used according to the present invention can be prepared by mixing the halide and silver solutions in partially or fully controlled conditions of temperature, concentrations, sequence of addition, and rates of addition. The silver halide can be precipitated according to the single-jet method or the double-jet method.

The photosensitive silver halide particles of the photographic material used according to the present invention may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms.

The photosensitive silver halide particles are preferably of high speed and readily transferable by diffusion during the DTR-process. It is furthermore advantageous that the photosensitive silver halide particles show a rapid chemical development i.e. silver halide emulsions that show a complete chemical development within at least 15s. The rate of chemical development can be easily determined with the following method. The silver halide emulsion layer of which the rate of chemical development is to be measured is coated to a transparent support in an amount equivalent to 2g AgNO₃/m² and 2.1g gelatin/m². The thus obtained element is exposed to a suitable light-source and subsequently placed in a cuvette in a spectrophotometer and thermostated at 25°C. A developing solution is brought in the cuvette and the absorption at 800nm is followed with time. From the plot of the absorption at 800nm against time, the time necessary to obtain a complete development of the sample can be determined.

According to the present invention the photosensitive silver halide particles preferably consist principally of silver chloride while a fraction of silver bromide may be present ranging from 1 mole % to 40 mole %. The particles may be of the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated.

The size distribution of the photosensitive silver halide particles to be used according to the present invention can be homodisperse or heterodisperse. A homodisperse size distribution is obtained when 95% of the grains have a size that does not deviate more than 30% from the average grain size.

Preferably during the precipitation stage Iridium and/or Rhodium containing compounds or a mixture of both are added. The concentration of these added compounds ranges from 10⁻⁸ to 10⁻³ mole per mole of AgNO₃, preferably between 10⁻⁷ and 10⁻⁴ mole per mole of AgNO₃. This results in the building in the silver halide crystal lattice of minor amounts of Iridium and/or Rhodium, so-called Iridium and/or Rhodium dopants. As known to those skilled in the art numerous scientific and patent publications disclose the addition of Iridium or Rhodium containing compounds or compounds containing other elements of Group VIII of the Periodic System during emulsion preparation.

The photosensitive silver halide particles can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P-493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The photosensitive silver halide particles of the photographic element of the present invention can be spectrally sensitized according to the spectral emission of the exposure source for which the photographic element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

To enhance the sensitivity in the near infra-red region use can be made of so-called supersensitizers in combination with infra-red sensitizing dyes. Suitable supersensitizers are described in Research Disclosure Vol 289, May 1988, item 28952.

The spectral sensitizers can be added to the photosensitive emulsion(s) in the form of an aqueous solution, a solution in an organic solvent or in the form of a dispersion.

The silver halide emulsions may contain the usual stabilizers e.g. homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P-3,692,527.

More details about the composition, preparation and coating of silver halide emulsions can be found in e.g. Product Licensing Index, Vol. 92, December 1971, publication 9232, p. 107-109.

According to the present invention, the layer comprising said light sensitive silver halide particles, and said substantially light insensitive silver salts also contains the physical development nuclei.

Suitable physical development nuclei for use in accordance with the present invention are e.g. colloidal silver, heavy metal sulphides e.g. silver sulphide, nickel sulphide, cobalt sulphide, silver nickel sulphide etc.. Preferred physical development nuclei are colloidal silver and silver nickel sulphides.

The photographic layer containing said light sensitive silver halide particles, said substantially light insensitive silver salts and said physical development nuclei may contain pH controlling ingredients. Preferably said photographic layer is coated at a pH value below the isoelectric point of the gelatin to improve the stability characteristics of the coated layer. Other ingredients such as antifogging agents, development accelerators, wetting agents, and hardening agents for gelatin may be present. Said photographic layer may comprise light-screening dyes that absorb scattering light and thus promote the image sharpness. Suitable light-absorbing dyes are described in i.a. US-P-4,092,168, US-P-4,311,787, DE-P-2,453,217.

Development acceleration can be accomplished with the aid of various compounds, preferably polyalkylene derivatives having a molecular weight of at least 400 such as those described in e.g. US-P-3,038,805 - 4,038,075 - 4,292,400.

The photographic material of the present invention may contain additional hydrophilic layers in water permeable relationship with said photographic layer. For example a hydrophillic layer may be applied as an outermost layer as a protecting or anti-stress layer.

In a preferred embodiment of the present invention an intermediate hydrophilic layer, serving as antihalation layer, is provided between the support and the silver halide emulsion layer. This layer can contain the same light-absorbing dyes as described above for the emulsion layer ; as alternative finely divided carbon black can be used for the same antihalation purposes as described in US-P-2,327,828. On the other hand, in order to gain sensitivity, light reflecting pigments,e.g. titaniumdioxide can be present. Further this layer may contain hardening agents, matting agents, e.g. silica particles, and wetting agents.

The hydrophilic layers comprised in a photographic material according to the invention usually contain gelatin as hydrophilic colloid binder. Mixtures of different gelatins with different viscosities can be used to adjust the rheological properties of the layer. The additional hydrophilic layers are coated preferably at a pH value below the isoelectric point of the gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.

The hydrophilic layers of a photographic element according to the invention, especially when the binder used is gelatin, can be hardened with appropriate hardening agents such as those of the epoxide type, those of the ethylenimine type, those of the vinylsulfone type e.g. 1,3-vinylsulphonyl-2-propanol, chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

The photographic element used according to the present invention may further comprise various kinds of surface-active agents in the photographic emulsion layer or in at least one other hydrophilic colloid layer. Suitable surface-active agents include non-ionic agents such as saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Preferably compounds containing perfluorinated alkyl groups are used. Such surface-active agents can be used for various purposes e.g. as coating aids, as compounds preventing electric charges, as compounds improving slidability, as compounds facilitating dispersive emulsification and as compounds preventing or reducing adhesion.

The photographic element of the present invention may further comprise various other additives such as e.g. compounds improving the dimensional stability of the photographic element, UV-absorbers, spacing agents or matting agents and plasticizers. Preferred spacing agents are SiO₂ particles having an average size of from 0.8µm to 15µm. These spacing agents may be present in one or more layers comprised on the support of the photographic material.

Suitable additives for improving the dimensional stability of the photographic element are e.g. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

The support of the photographic material used in accordance with the present invention can be any of the support materials customarily employed in the art. They include paper coated on one or both sides with an Alpha-olefin polymer, e.g. polyethylene, glass or film, e.g. cellulose acetate film, polyvinyl acetal film, polystyrene film, polyethylene terephthalate film etc.. Polyethylene terephthalate film coated with a subbing layer to improve the adhesion of the thereon deposited layers of the invention is preferred. When the photographic material of the present invention is intended for use in COM-applications it is desirable that the support is highly antistatic and should therefore be highly electroconductive.

According to the method of the present invention the photographic material is information-wise exposed and subsequently developed in an alkaline processing solution in the presence of (a) developing agent(s) and (a) silver halide solvent(s).

The photographic material of the present invention is exposed in an apparatus according to its particular application, e.g. a conventional process camera containing a conventional light source or a laser containing device.

Suitable developing agents for developing the photographic material in connection with the present invention are e.g. hydroquinone-type and 1-phenyl-3-pyrazolidone-type developing agents as well as p-monomethylaminophenol and derivatives thereof. Preferably used is a combination of a hydroquinone-type and 1-phenyl-3-pyrazolidone-type developing agent whereby the latter is preferably incorporated in one of the layers comprised on the support of the photographic material. A preferred class of 1-phenyl-3-pyrazolidone-type developing agents is disclosed in the EP-A-449,340. It was found that most advantage of the present invention is taken when at least one of the there disclosed developing agents is present in the photographic material of the present invention preferably in the layer comprising the physical development nuclei, the light sensitive and substantially light insensitive silver salt particles. Other type of developing agents suitable for use in accordance with the present invention are reductones e.g. ascorbic acid derivatives. Such type of developing agents are disclosed in EP-A-498,968.

The developing agent or a mixture of developing agents can be present in an alkaline processing solution and/or in the photographic material. In case the developing agent or a mixture of developing agents is contained in the photographic material, the processing solution can be merely an aqueous alkaline solution that initiates and activates the development.

The pH of the alkaline processing solution is preferably between 9 and 13. The desired pH of the processing solution can be reached by incorporating alkaline substances in the processing solution. Suitable alkaline substances are inorganic alkali e.g. sodium hydroxide, potassium carbonate or aminoalkohols or mixtures thereof. Preferably used alkanolamines are tertiary alkanolamines e.g. those described in EP-A-397,925, EP-A-397,926, EP-A-397,927, EP-A-398,435 and US-P-4,632,896. A combination of alkanolamines having both a pKₐ above or below 9 or a combination of alkanolamines whereof at least one has a pKₐ above 9 and another having a pKₐ of 9 or less may also be used as disclosed in the Japanese patent applications laid open to the public numbers 73949/63, 73953/61, 169841/61, 212670/60, 73950/61, 73952/61, 102644/61, 226647/63, 229453/63, US-P-4,362,811, US-P-4,568,634 etc.. The concentration of these alkanolamines is preferably from 0.1 mole/l to 0.9 mole/l.

Preferably used silver halide solvents are water soluble thiosulphate compounds such as ammonium and sodium thiosulphate. Other useful silver halide solvents (or "complexing agents") are described in the book "The Theory of the Photographic Process" edited by T.H. James, 4th edition, p. 474-475 (1977), in particular sulphites and uracil. Further interesting silver halide complexing agents are cyclic imides, preferably combined with alkanolamines, as described in US 4,297,430 and US 4,355,090. 2-mercaptobenzoic acid derivatives are described as silver halide solvents in US 4,297,429, preferably combined with alkanolamines or with cyclic imides and alkanolamines.

The silver halide solvent(s) may be partly or completely present in the photographic material. When the silver halide solvent is incorporated in the photographic material it may be incorporated as a silver halide solvent precursor as disclosed in e.g. Japanese published unexamined patent applications no. 15247/59 and 271345/63, US-P-4,693,955 and US-P-3,685,991. Developing of the information-wise exposed photographic material is preferably carried out using a single processing liquid. However use can be made of two processing liquids whereby only the second liquid that is applied comprises a silver halide solvent. The DTR-development step may also be followed by a fixing step.

The present invention is illustrated with the following examples without limiting it thereto. All parts are by weight unless otherwise specified.

### EXAMPLE 1

### Preparation of the substantially non-light sensitive silver chloride emulsion (a).

| | | | |
|---|---|---|---|
| Solution A (35°C): | water | | 500ml |
| | AgNO₃ | 2.94 M (water) | 1000ml |
| Solution B (35°C): | water | | 500ml |
| | NaCl | 3.94 M (water) | 790ml |
| Solution C (35°C): | water | | 2250ml |
| | gelatin | | 70g |

Solution C was brought to 45°C and 65ml of a solution containing 0.136% Na₃RhCl₆ was added. After adjusting the pH to 3.5 solution A and B were added simultaneously to solution C in ten minutes. The resulting emulsion was precipitated by adding polystyrene sulphonic acid. The precipitate was rinsed several times and redispersed by adding 180g of gelatin to a final content of 200g of AgNO₃ per kg of emulsion. The thus obtained emulsion was physically ripened for 2 hours. A substantially non-light sensitive silver chloride emulsion was thus obtained. The average diameter of the grains was 0.178µm. This emulsion was stabilized with 1-phenyl-5-mercaptotetrazole (23.6µmole per gram of AgNO₃) at pH=4 (1 hour stirring at 38°C).

### Preparation of the light sensitive silver chloride emulsion (b).

| | | | |
|---|---|---|---|
| Solution D (50°C): | AgNO₃ | 2.94 M (water) | 1000ml |
| Solution E (50°C): | NaCl | 2.94 M (water) | 1000ml |
| Solution F (60°C): | water | | 870ml |
| | gelatin | | 46g |
| | methionine | 25g/l | 200ml |
| | NaCl | 3.94 M (water) | 9.5ml |

Solution D and solution E were added to solution F at a constant rate of 1.8 ml per minute for 300 seconds. Solution D was further added in 3398 seconds at an accelerating rate from 5 to 30 ml per minute, while solution E was further added at a rate so as to keep the pAg at 75mV. This emulsion was chemically sensitized at 60°C with potassium iodide (1.51 mmole), para-toluene thiosulphonic acid (40 µmole), gold chloride (80 µmole), potassium iodide (1.33mmole) and 1-phenyl-5-mercaptotetrazole (210µmole). The chemically ripened emulsion was precipitated by adding polystyrene sulphonic acid. The precipitate was rinsed several times and redispersed by adding 129g of gelatin to a final content of 200g of AgNO₃ per kg of emulsion. A silver chloride emulsion with an average diameter of the grains of 1.01µm was thus obtained. This emulsion was further spectrally sensitized with an ortho sensitizer (1.73 µmol per gram of AgNO₃) at pH=4.

The different samples were prepared as follows. To a polyethylene terephthalate film support coated with a hydrophilic adhesion layer was coated a layer comprising a mixture of the substantially light insensitive silver chloride emulsion and of the photosensitive silver chloride emulsion to wich were added physical development nuclei from the type (NiS)_{0.8}(Ag₂S)_{0.2} .

Each tested layer contained 0.8 g AgNO₃/m² of emulsion (a), 0.4 g AgNO₃/m² of emulsion (b) and 7.6 mg/m² of the nuclei with a total of 2.6 g gelatine/m². Different amounts of 1-phenyl-5-mercaptotetrazole (PMT) were added to the physical development nuclei before they were mixed with the two emulsions. The amounts are given in table 1.

The samples were exposed (EG&G; 10⁻⁵sec; U460 filter) through a discontinuous wedge (wedgeconstant=0.15). Only the light sensitive silver halide emulsion is sensitive for this exposure.

After the exposure the samples were subsequently developed using an alkaline developer liquid CP297b (commercially available from Agfa-Gevaert N.V.) containing hydroquinone and 1-phenyl-4-methyl-3-pyrazolidone as developing agents and thiosulphate as a silver halide solvent.

For each of the samples the minimum and maximum transmission density and the speed were measured. These results are shown in table 1.

**Table 1**

| PMT (µmole/m²) | Dmin | Dmax | Speed* |
|---|---|---|---|
| 0 | 0.15 | 1.35 | 8 |
| 0.18 | 0.15 | 1.30 | 10 |
| 0.36 | 0.15 | 1.26 | 11 |
| 0.72 | 0.15 | 1.38 | 10 |
| 1.44 | 0.15 | 1.28 | 10 |
| 2.88 | 0.15 | 1.22 | 11 |

| | | | |
|---|---|---|---|
| *The speed is expressed as the number of wedgeconstants for which the density equals Dmin + 0.1. A higher number indicates a higher speed. | | | |

### EXAMPLE 2

To a polyethylene terephthalate film support coated with a hydrophilic adhesion layer was coated a layer comprising a mixture of the substantially light insensitive silver chloride emulsion (a) and of the photosensitive silver chloride emulsion (b) as described in example 1 to wich were added physical development nuclei from the type Ag°.

Each tested layer contained 0.8 g AgNO₃/m² of emulsion (a), 0.4 g AgNO₃ of emulsion (b) and 11.4 (1) or 22.8 (2) µmole of Ag°nuclei/m² with a total of 2.6 g gelatine/m². Different amounts of 1-phenyl-5-mercaptotetrazole (PMT) were added to the physical development nuclei before they were mixed with the two emulsions. The amounts are given in table 2 together with the sensitometric results.

**Table 2**

| Ag°-nuclei/m² | PMT (µmole/m²)² | Dmin | Dmax | Speed* |
|---|---|---|---|---|
| (1) | 0 | 0.12 | 0.72 | 12 |
| (1) | 0.18 | 0.12 | 0.86 | 13 |
| (2) | 0 | 0.12 | 0.85 | 12 |
| (2) | 0.36 | 0.12 | 1.23 | 11 |

| | | | | |
|---|---|---|---|---|
| *The speed is expressed as the number of wedgeconstants for which the density equals Dmin + 0.1. A higher number indicates a higher speed. | | | | |

## Claims

1. A photographic material comprising on a support a layer combining photosensitive and image receiving properties, said layer containing (i) light sensitive silver halide particles, (ii) a substantially light insensitive silver salt having a speed of at least a factor 10 less than said light sensitive silver halide particles and (iii) physical development nuclei.

2. A photographic material according to claim 1 wherein said light sensitive silver halide particles have an average diameter of at least 0.5µm.

3. A photographic material according to claim 1 wherein the average diameter of said light sensitive silver halide is at least 0.8µm.

4. A photographic material according to claim 2 or 3 wherein said light sensitive silver halide particle are applied at a coverage of at least 0.2g/m² expressed as AgNO₃ and whereby the ratio of said coverage (in g/m² expressed as AgNO₃) to said average diameter (in µm) is not more than 2

5. A photographic material according to any of the claims 1 to 4 wherein the weight ratio of said photosensitive silver halide to said substantially light insensitive silver salt is between 2:1 and 1:5.

6. A photographic material according to any of claims 1 to 5 wherein said substantially light insensitive silver salt comprises at least 70 mol% of silver chloride.

7. A photographic material according to any of the claims 1 to 6 wherein said substantially light insensitive silver salts are not chemically or spectrally sensitized.

8. A photographic material according to any of claims 1 to 7 wherein the average diameter of said substantially light insensitive silver salt is not more than 0.3µm.

9. A photographic material according to any of the claims 1 to 8 wherein said physical development nuclei are silver or silver-nickel sulfide nuclei.

10. A method for obtaining an image comprising the steps of (i) information-wise exposing a photographic material according to any of the claims 1 to 9 and (ii) developing a thus obtained information-wise exposed photographic material in the presence of developing agent(s) and silver halide solvent(s).
